(19) Europäisches Patentamt
European Patent Office
Office européen des brevets

(11) **EP 2 522 454 A1**

(12) **EUROPÄISCHE PATENTANMELDUNG**

(43) Veröffentlichungstag:
**14.11.2012 Patentblatt 2012/46**

(51) Int Cl.:
*B23K 26/34* (2006.01)     *C30B 13/24* (2006.01)
*C30B 29/52* (2006.01)     *F01D 5/00* (2006.01)

(21) Anmeldenummer: **11165301.0**

(22) Anmeldetag: **09.05.2011**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(71) Anmelder:
• **Siemens Aktiengesellschaft**
  **80333 München (DE)**
• **Fraunhofer-Gesellschaft zur Förderung der angewandten Forschung e.V.**
  **80686 München (DE)**

(72) Erfinder: **Die Erfindernennung liegt noch nicht vor**

(54) **Einkristallines Schweißen von direktional verfestigten Werkstoffen**

(57) Durch die gezielte Auswahl von Verfahrensparametern bei Laserschweißen, Vorschub, Laserleistungsstrahldurchmesser und Pulvermassenstrom kann der Temperaturgradient gezielt eingestellt werden, der wesentlich entscheidend ist zum einkristallinen Wachstum beim Laserauftragsschweißen.

FIG 1

EP 2 522 454 A1

**Beschreibung**

Die Erfindung betrifft ein Schweißverfahren von direktional verfestigten metallischen Werkstoffen.

γ'-verstärkte SX Nickelbasis-Superlegierungen lassen sich weder mittels konventioneller Schweißverfahren noch mit Hochenergieverfahren (Laser, Elektronenstrahl) mit artgleichen Zusatzwerkstoffen in überlappenden Schweißbahnen in ein oder mehreren Lagen auftragsschweißen. Das Problem liegt darin, dass sich bereits bei einer einzelnen Schweißbahn im oberflächennahen Randbereich ein Gefüge mit Fehlorientierung ausbildet. Für die nachfolgende Überlappspur bedeutet das, dass die Erstarrungsfront in diesem Bereich keinen SX Keim zur Verfügung hat und sich der Bereich mit Fehlorientierung (kein SX Gefüge) im Überlappbereich weiter ausdehnt. In diesem Bereich kommt es zur Rissbildung.

Die bisher verwendeten Schweißverfahren sind nicht in der Lage, für γ'-verstärkte SX Nickelbasis-Superlegierungen ein Schweißgut in Überlappbearbeitung in ein oder mehreren Lagen artgleich mit identischem SX Gefüge aufzubauen. Bei einer Einzelspur auf einem SX Substrat variieren die lokalen Erstarrungsbedingungen in der Weise, dass je nach Position ein dendritisches Wachstums ausgehend von den Primärstämmen oder den Sekundärarmen initiiert wird. Dabei setzt sich von den verschiedenen möglichen dendriten Wachstumsrichtungen die mit den günstigsten Wachstumsbedingungen durch, d.h. die mit dem kleinsten Neigungswinkel zum Temperaturgradienten. Die Ursache für die Ausbildung von Fehlorientierungen im SX Gefüge beim Pulver-Auftragsschweißen von γ'-verstärkten SX Nickelbasis-Superlegierungen ist z. Zt. nicht vollständig geklärt. Man vermutet, dass beim Aufeinandertreffen der Dendriten aus verschiedenen Wachstumsrichtungen möglicherweise Sekundärarme abbrechen und als Keime für die Ausbildung eines fehlorientierten Gefüges dienen. Darüber hinaus können im oberflächennahen Randbereich nicht vollständig aufgeschmolzene Pulverpartikel in der Schmelze als Keime für die Ausbildung eines fehlorientierten Gefüges dienen. Zur Lösung des Problems wird deshalb eine Prozessführung für das Pulver-Auftragsschweißen von y'-verstärkten SX Nikkelbasis-Superlegierungen vorgeschlagen, bei der Wachstumsbedingungen realisiert werden, die nur eine Wachstumsrichtung für die Dendriten favorisieren. Darüber hinaus stellt die Prozessführung ein vollständiges Aufschmelzen der Pulverpartikel in der Schmelze sicher.

Es ist daher Aufgabe der Erfindung o. g. Problem zu lösen.

Die Aufgabe wird gelöst durch ein Verfahren gemäß Anspruch 1.

Zur Lösung dieses technischen Problems der Ausbildung eines nicht einkristallinen Gefüges im oberflächennahen Randbereich einer Einzelspur wird eine Prozessführung für das Auftragsschweißen mit Laserstrahlung vorgeschlagen, bei der dieses Problem nicht auftritt oder in so einem geringen Maße, dass Überlappbearbeitung in ein oder mehreren Lagen ohne Rissbildung bei Raumtemperatur möglich ist.

In den Unteransprüchen sind weitere vorteilhafte Maßnahmen aufgelistet, die beliebig miteinander kombiniert werden können, um weitere Vorteile zu erzielen.

Es zeigen:

Figur 1        einen schematischen Ablauf des Verfahrens,
Figur 2        eine Gasturbine,
Figur 3        eine Turbinenschaufel,
Figur 4        eine Liste von Superlegierungen,
Figur 5, 6     Schweißraupen.

Die Beschreibung und die Figuren stellen nur Ausführungsbeispiele der Erfindung dar.

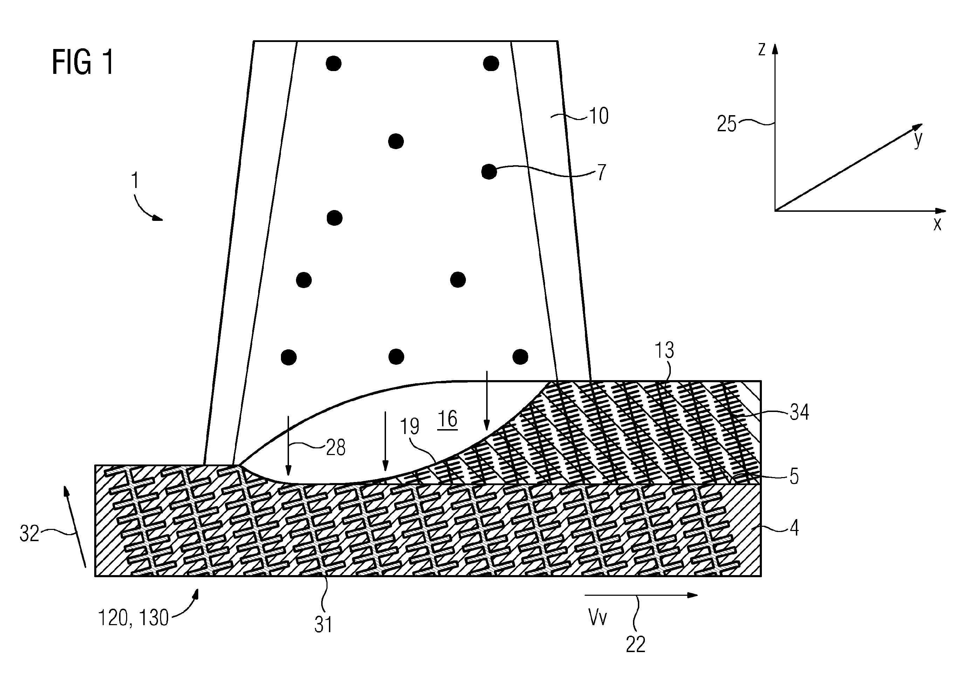

In Figur 1 ist schematisch der Ablauf des Verfahrens dargestellt mit einer Vorrichtung 1.

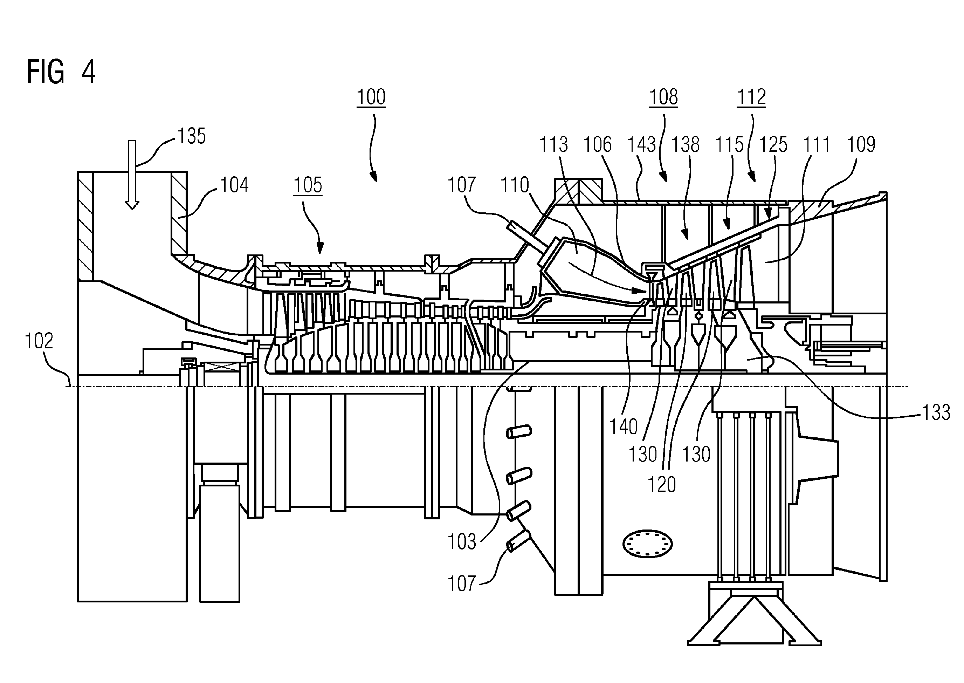

Das zu reparierende Bauteil 120, 130 weist ein Substrat 4 aus einer Superlegierung, insbesondere aus einer nickelbasierten Superlegierung gemäß Figur 4 auf.

Ganz insbesondere besteht das Substrat 4 aus einer Nickelbasissuperlegierung.

Das Substrat 4 wird repariert, indem neues Material 7, insbesondere mittels Pulver auf die Oberfläche 5 des Substrats 4 durch Auftragsschweißen aufgebracht wird.

Dies erfolgt durch die Zufuhr von Material 7 und einem Schweißstrahl, vorzugsweise einem Laserstrahl 10 eines Lasers, der zumindest das zugeführte Material 7 aufschmilzt und vorzugsweise auch teilweise das Substrat 4.

Dabei wird vorzugsweise Pulver verwendet. Vorzugsweise ist der Durchmesser der Pulverteilchen 7 so klein, dass ein Laserstrahl sie vollständig aufschmelzen und eine hinreichend hohe Temperatur der Teilchen 7 ergibt.

Dabei gibt es auf dem Substrat 4 während des Schweißens einen aufgeschmolzenen Bereich 16 und eine sich daran anschließende Erstarrungsfront 19 und davor ein schon wieder erstarrter Bereich 13.

Die Vorrichtung der Erfindung umfasst vorzugsweise einen Laser (nicht dargestellt) mit einer Pulverzuführeinheit und ein Bewegungssystem (nicht dargestellt), mit dem die Laserstrahlwechselwirkungszone und der Auftreffbereich für das Pulver 7 auf der Substratoberfläche 5 bewegt werden können. Das Bauteil (Substrat 4) wird dabei vorzugsweise weder vorgewärmt, noch mittels einer Wärmebehandlung überaltert.

Der zu rekonstruierende Bereich auf dem Substrat 4 wird vorzugsweise lagenweise auftragsgeschweißt.

Die Lagen werden vorzugsweise mäanderförmig, uni- oder bidirektional aufgetragen, wobei die Scanvektoren der Mäanderfahrten von Lage zu Lage vorzugsweise jeweils um 90° gedreht werden, um Anbindefehler zwischen den Lagen zu vermeiden.

Die Dendriten 31 im Substrat 4 und die Dendriten 34 im aufgetragenen Bereich 13 sind in der Figur 1 dargestellt.

Ein Koordinatensystem 25 ist ebenfalls dargestellt.

Das Substrat 4 bewegt sich relativ in x-Richtung 22 mit der Scangeschwindigkeit $V_v$.

Auf der Erstarrungsfront 19 gibt es den z-Temperaturgradienten

$$\frac{\partial T}{\partial Z} \quad 28.$$

Der Schweißprozess wird mit Verfahrensparametern bzgl. Vorschub $V_v$, Laserleistung, Strahldurchmesser und Pulvermassenstrom durchgeführt, die zu einer lokalen Orientierung des Temperaturgradienten auf der Erstarrungsfront führt, der vorzugsweise kleiner als 45° zur Richtung der Dendriten 31 im Substrat 4 ist. Dadurch wird gewährleistet, dass ausschließlich die Wachstumsrichtung für die Dendriten 34 favorisiert wird, die die Dendritenrichtung 32 im Substrat 4 fortsetzt. Dafür notwendig ist ein Strahlradius, der gewährleistet, dass der Teil der Dreiphasenlinien, der die Erstarrungsfront 19 berandet, vollständig von dem Laserstrahl überdeckt wird.

Die approximative Bedingung für eine geeignete Neigung der Erstarrungsfront 19 zur Dendritenrichtung 32 der Dendriten 31 im Substrat 4 lautet vorzugsweise:

$$\frac{\frac{1}{\lambda} * A * I_L}{\sqrt{\left(\frac{\partial T}{\partial x}(V_V)\right)^2 + \left(\frac{\partial T}{\partial \gamma}(V_V)\right)^2 + \left(\frac{1}{\lambda} + A * I_L\right)^2}} \geq 0.707 = \cos(45°)$$

A: Absorptionsgrad vom Substrat,
$I_L$: Laserintensität,
$V_v$: Scangeschwindigkeit,
λ: Wärmeleitfähigkeit des Substrats,
T: Temperatur

Aus der Bedingung ergibt sich werkstoffabhängig ein Prozessfenster bzgl. der Intensität der Laserstrahlung (approximativ top hat), dem Strahlradius relativ zum Pulverstrahlfokus, der Vorschubgeschwindigkeit $V_v$ und dem Pulvermassenstrom.

Durch die vollständige Überdeckung der Schmelze mit der Laserstrahlung wird bei der koaxialen Prozessführung eine längere Wechselwirkungszeit der Pulverpartikel mit der Laserstrahlung und eine damit höhere Partikeltemperatur beim Kontakt mit der Schmelze gewährleistet.

Der Partikeldurchmesser und damit die vorgegebene Wechselwirkungszeit sollen ein zum vollständigen Aufschmelzen ausreichend hohes Temperaturniveau bewirken. Ein ausreichend hohes Temperaturniveau der Schmelze soll bei gegebener Partikeltemperatur und Verweilzeit in der Schmelze bewirken, dass die Partikel vollständig in Schmelze gehen.

Durch die oben beschriebenen Verfahrensparameter und Mechanismen werden die Voraussetzungen für ein epitaktisches einkristallines Wachstum im Schweißgut mit einer im Substrat identischen Dendritenorientierung gewährleistet. Dadurch, dass beim Schweißprozess nur eine Dendritenwachstumsrichtung normal zur Oberfläche aktiviert ist, wird beim Erstarren ein Nachfließen der Schmelze in den interdendritischen Raum erleichtert und die Bildung von Heißrissen vermieden.

Dies resultiert in einer Qualität der Schweißung, die für eine strukturelle Schweißung (z. B. zum Zwecke einer Reparatur oder Fügung in einem hochbelasteten Bereich des Bauteils) akzeptabel sind.

Die relative Geschwindigkeit $V_v$ beträgt vorzugsweise zwischen 30mm/min bis 100mm/min, vorzugsweise 50mm/min.

Die Leistung liegt in dem Bereich von vorzugsweise 200W bis 500W, ganz vorzugsweise bei 300W, wobei der Laserstrahl auf der Oberfläche einen Durchmesser von 3mm bis 6mmm, vorzugsweise 4mm aufweist.

Die Massenzufuhrrate beträgt vorzugsweise 300mg/min bis 600mg/min, vorzugsweise 400mg/min.

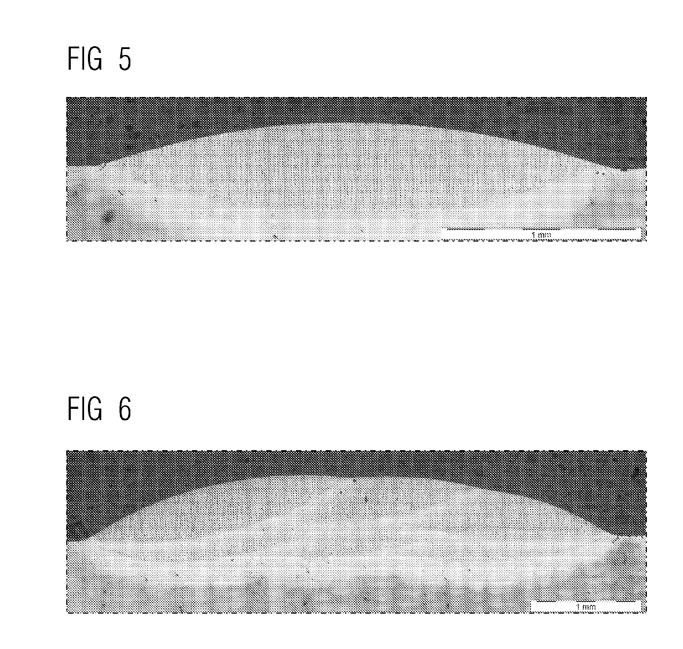

Im Vergleich zum Stand der Technik wird nicht oder nur zeitweise das Kriterium $G^n/v$ für eine einkristalline bzw. kolumnare dendritische Erstarrung verwendet (siehe Arbeiten von M. Gäumann). Im Vergleich zum Stand der Technik werden durch den entwickelten Prozess die oben genannten Verfahrensparameter Laserstrahldurchmesser, Laserleistung, Verfahrgeschwindigkeit, Pulvermassenstrom so angepasst, dass die auftraggeschweißte Spur (Fig. 5) oder Spuren (Fig. 6) vollständig einkristallin mit einer Dendritenorientierung erstarren (siehe Fig. 5). Diese gebildete Gefügestruktur verkleinert die Anfälligkeit für die Bildung von fehlorientierten Körnern und damit die Rissbildung durch eine durchgängige duktile interdendritische Matrix auch der Horizontalspannungen beim Auftragschweißen von Mehrlagenschichten (siehe Fig. 6).

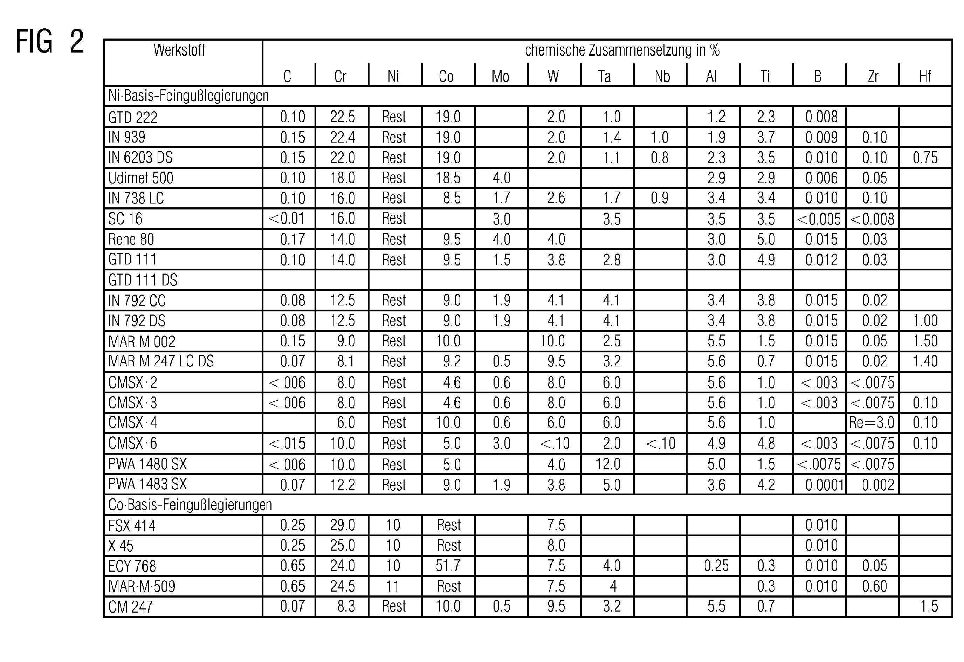

Die Figur 2 zeigt beispielhaft eine Gasturbine 100 in einem Längsteilschnitt.

Die Gasturbine 100 weist im Inneren einen um eine Rotationsachse 102 drehgelagerten Rotor 103 mit einer Welle 101 auf, der auch als Turbinenläufer bezeichnet wird.

Entlang des Rotors 103 folgen aufeinander ein Ansauggehäuse 104, ein Verdichter 105, eine beispielsweise torusartige Brennkammer 110, insbesondere Ringbrennkammer, mit mehreren koaxial angeordneten Brennern 107, eine Turbine 108 und das Abgasgehäuse 109.

Die Ringbrennkammer 110 kommuniziert mit einem beispielsweise ringförmigen Heißgaskanal 111. Dort bilden beispielsweise vier hintereinander geschaltete Turbinenstufen 112 die Turbine 108.

Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.

An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 110 auskleidenden Hitzeschildelementen am meisten thermisch belastet.

Um den dort herrschenden Temperaturen standzuhalten, können diese mittels eines Kühlmittels gekühlt werden.

Ebenso können Substrate der Bauteile eine gerichtete Struktur aufweisen, d.h. sie sind einkristallin (SX-Struktur) oder weisen nur längsgerichtete Körner auf (DS-Struktur).

Als Material für die Bauteile, insbesondere für die Turbinenschaufel 120, 130 und Bauteile der Brennkammer 110 werden beispielsweise eisen-, nickel- oder kobaltbasierte Superlegierungen verwendet.

Solche Superlegierungen sind beispielsweise aus der EP 1 204 776 B1, EP 1 306 454, EP 1 319 729 A1, WO 99/67435 oder WO 00/44949 bekannt.

Ebenso können die Schaufeln 120, 130 Beschichtungen gegen Korrosion (MCrAlX; M ist zumindest ein Element der Gruppe Eisen (Fe), Kobalt (Co), Nickel (Ni), X ist ein Aktivelement und steht für Yttrium (Y) und/oder Silizium, Scandium (Sc) und/oder zumindest ein Element der Seltenen Erden bzw. Hafnium). Solche Legierungen sind bekannt aus der EP 0 486 489 B1, EP 0 786 017 B1, EP 0 412 397 B1 oder EP 1 306 454 A1.

Auf der MCrAlX kann noch eine Wärmedämmschicht vorhanden sein, und besteht beispielsweise aus $ZrO_2$, $Y_2O_3$-$ZrO_2$, d.h. sie ist nicht, teilweise oder vollständig stabilisiert durch Yttriumoxid und/oder Kalziumoxid und/oder Magnesiumoxid.

Durch geeignete Beschichtungsverfahren wie z.B. Elektronenstrahlverdampfen (EB-PVD) werden stängelförmige Körner in der Wärmedämmschicht erzeugt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

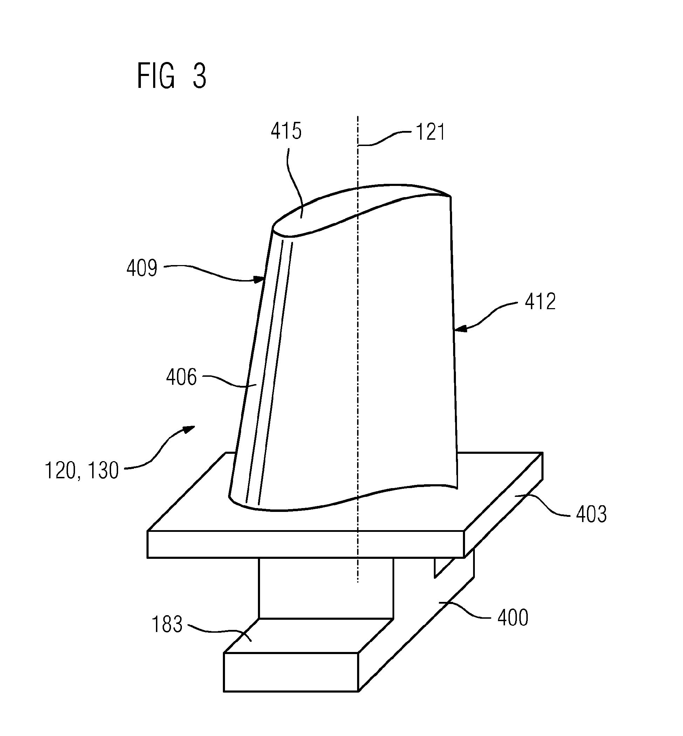

Die Figur 3 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 und eine Schaufelspitze 415 auf.

Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).

Der Schaufelfuß 183 ist beispielsweise als Hammerkopf ausgestaltet. Andere Ausgestaltungen als Tannenbaum- oder Schwalbenschwanzfuß sind möglich.

Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.

Solche Superlegierungen sind beispielsweise aus der EP 1 204 776 B1, EP 1 306 454, EP 1 319 729 A1, WO 99/67435 oder WO 00/44949 bekannt.

Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind.

Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.

Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.

Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures).

Solche Verfahren sind aus der US-PS 6,024,792 und der EP 0 892 090 A1 bekannt.

Ebenso können die Schaufeln 120, 130 Beschichtungen gegen Korrosion oder Oxidation aufweisen, z. B. (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1.

Die Dichte liegt vorzugsweise bei 95% der theoretischen Dichte.

Auf der MCrAlX-Schicht (als Zwischenschicht oder als äußerste Schicht) bildet sich eine schützende Aluminiumoxidschicht (TGO = thermal grown oxide layer).

Vorzugsweise weist die Schichtzusammensetzung Co-30Ni-28Cr-8Al-0,6Y-0,7Si oder Co-28Ni-24Cr-10Al-0,6Y auf. Neben diesen kobaltbasierten Schutzbeschichtungen werden auch vorzugsweise nickelbasierte Schutzschichten verwendet wie Ni-10Cr-12Al-0,6Y-3Re oder Ni-12Co-21Cr-11Al-0,4Y-2Re oder Ni-25Co-17Cr-10Al-0,4Y-1,5Re.

Auf der MCrAlX kann noch eine Wärmedämmschicht vorhanden sein, die vorzugsweise die äußerste Schicht ist, und besteht beispielsweise aus $ZrO_2$, $Y_2O_3$-$ZrO_2$, d.h. sie ist nicht, teilweise oder vollständig stabilisiert durch Yttriumoxid und/oder Kalziumoxid und/oder Magnesiumoxid.

Die Wärmedämmschicht bedeckt die gesamte MCrAlX-Schicht. Durch geeignete Beschichtungsverfahren wie z.B. Elektronenstrahlverdampfen (EB-PVD) werden stängelförmige Körner in der Wärmedämmschicht erzeugt.

Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen. Die Wärmedämmschicht ist also vorzugsweise poröser als die MCrAlX-Schicht.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

**Patentansprüche**

1. Verfahren zur direktionalen Verfestigung einer Schweißnaht (13) während des Auftragsschweißens, insbesondere zum Auftragsschweißen eines Substrats (4) eines Bauteils (1, 120, 130),
das (4) gerichtet verfestigt ist
und Dendriten (31) aufweist,
die (31) sich in einer Substratdendritenrichtung (32) erstrecken,
bei dem die Verfahrensparameter bezüglich Vorschub, Laserleistung, Schweißstrahldurchmesser, Pulverstrahlfokus und/oder Pulvermassenstrom derart ausgestaltet sind,
dass sie zu einer lokalen Orientierung des Temperaturgradienten (28) auf einer Erstarrungsfront (19) führen,
die insbesondere kleiner als 45° zur Substratdendritenrichtung (32) der Dendriten (31) im Substrat (4) ist,
und bei dem das Verfahren $G^n/v$-Faktoren zumindest zeitweise, insbesondere vollständig, außerhalb der $G^n/v$-Faktoren für einkristallines oder kolumnares dendritisches Wachstum aufweist.

2. Verfahren nach Anspruch 1,
bei dem die Relativgeschwindigkeit zwischen 30mm/min und 100mm/min,
vorzugsweise 50mm/min beträgt.

3. Verfahren nach einem oder mehreren der Ansprüche 1 oder 2,
die Leistung zwischen 200W und 500W,
vorzugsweise 300W beträgt.

4. Verfahren nach einem oder mehreren der Ansprüche 1, 2 oder 3,
der Durchmesser des Laserstrahls auf der Oberfläche des Substrats (4) zwischen 3mm und 6mm, vorzugsweise bei 4mm beträgt.

5. Verfahren nach einem oder mehreren der Ansprüche 1, 2, 3 oder 4,
die Massenzufuhrrate zwischen 300mg/min und 600mg/min, vorzugsweise bei 400mg/min beträgt.

6. Verfahren nach einem oder mehreren der Ansprüche 1, 2, 3, 4 oder 5,
bei dem eine Schmelze (16) auf und in dem Substrat (4) entsteht,
die durch die Zufuhr von Pulver (7) und/oder Material des Substrats (4) generiert wird,
und bei dem die Schmelze (16) vollständig von einem Schweißstrahl (10),
insbesondere einem Laserstrahl,
bedeckt wird,
insbesondere bei dem die Schmelze (16) überlappt wird.

7. Verfahren nach einem oder mehreren der Ansprüche 1, 2, 3, 4, 5 oder 6,
bei dem zugeführtes Pulver (7) lagenweise aufgetragen wird.

8. Verfahren nach einem oder mehreren der Ansprüche 1, 2, 3, 4, 5, 6 oder 7,
bei dem das Substrat (4) eine nickelbasierte Superlegierung aufweist,
das insbesondere kolumnare Körner aufweist,
ganz insbesondere ein einkristallines Gefüge aufweist.

9. Verfahren nach einem oder mehreren der Ansprüche 1, 2, 3, 4, 5, 6, 7 oder 8,
bei dem der Durchmesser der Pulverteilchen (7) so klein ist,
dass sie im Schweißlaserstrahl (10) insbesondere vollständig aufschmelzen und eine hinreichend hohe Temperatur aufweisen.

10. Verfahren nach einem oder mehreren der Ansprüche 1, 2, 3, 4, 5, 6, 7, 8 oder 9,
bei dem die Temperatur der aufgeschmolzenen Pulverteilchen (7) 20°C über der Schmelztemperatur der Pulverteilchen (7) liegt.

11. Verfahren nach einem oder mehreren der Ansprüche 1, 2, 3, 4, 5, 6, 7, 8, 9 oder 10,
bei dem ein Laser zum Schweißen verwendet wird.

12. Verfahren nach einem oder mehreren der Ansprüche 1, 2, 3, 4, 5, 6, 7, 8, 9, 10 oder 11,

bei dem gilt:

$$\frac{\dfrac{1}{\lambda} * \mathrm{A} * I_L}{\sqrt{\left(\dfrac{\partial T}{\partial x}(V_V)\right)^2 + \left(\dfrac{\partial T}{\partial \gamma}(V_V)\right)^2 + \left(\dfrac{1}{\lambda} + A * I_L\right)^2}} \geq 0.707 = \cos(45°)$$

A: Absorptionsgrad von Substrat,
$I_L$: Laserintensität,
$V_V$: Scangeschwindigkeit,
λ: Wärmeleitfähigkeit des Substrats.

FIG 1

EP 2 522 454 A1

**FIG 2**

EP 2 522 454 A1

| Werkstoff | chemische Zusammensetzung in % | | | | | | | | | | | | |
|---|---|---|---|---|---|---|---|---|---|---|---|---|---|
| | C | Cr | Ni | Co | Mo | W | Ta | Nb | Al | Ti | B | Zr | Hf |
| Ni-Basis-Feingußlegierungen | | | | | | | | | | | | | |
| GTD 222 | 0.10 | 22.5 | Rest | 19.0 | | 2.0 | 1.0 | | 1.2 | 2.3 | 0.008 | | |
| IN 939 | 0.15 | 22.4 | Rest | 19.0 | | 2.0 | 1.4 | 1.0 | 1.9 | 3.7 | 0.009 | 0.10 | |
| IN 6203 DS | 0.15 | 22.0 | Rest | 19.0 | | 2.0 | 1.1 | 0.8 | 2.3 | 3.5 | 0.010 | 0.10 | 0.75 |
| Udimet 500 | 0.10 | 18.0 | Rest | 18.5 | 4.0 | | | | 2.9 | 2.9 | 0.006 | 0.05 | |
| IN 738 LC | 0.10 | 16.0 | Rest | 8.5 | 1.7 | 2.6 | 1.7 | 0.9 | 3.4 | 3.4 | 0.010 | 0.10 | |
| SC 16 | <0.01 | 16.0 | Rest | | 3.0 | | 3.5 | | 3.5 | 3.5 | <0.005 | <0.008 | |
| Rene 80 | 0.17 | 14.0 | Rest | 9.5 | 4.0 | 4.0 | | | 3.0 | 5.0 | 0.015 | 0.03 | |
| GTD 111 | 0.10 | 14.0 | Rest | 9.5 | 1.5 | 3.8 | 2.8 | | 3.0 | 4.9 | 0.012 | 0.03 | |
| GTD 111 DS | | | | | | | | | | | | | |
| IN 792 CC | 0.08 | 12.5 | Rest | 9.0 | 1.9 | 4.1 | 4.1 | | 3.4 | 3.8 | 0.015 | 0.02 | |
| IN 792 DS | 0.08 | 12.5 | Rest | 9.0 | 1.9 | 4.1 | 4.1 | | 3.4 | 3.8 | 0.015 | 0.02 | 1.00 |
| MAR M 002 | 0.15 | 9.0 | Rest | 10.0 | | 10.0 | 2.5 | | 5.5 | 1.5 | 0.015 | 0.05 | 1.50 |
| MAR M 247 LC DS | 0.07 | 8.1 | Rest | 9.2 | 0.5 | 9.5 | 3.2 | | 5.6 | 0.7 | 0.015 | 0.02 | 1.40 |
| CMSX-2 | <.006 | 8.0 | Rest | 4.6 | 0.6 | 8.0 | 6.0 | | 5.6 | 1.0 | <.003 | <.0075 | |
| CMSX-3 | <.006 | 8.0 | Rest | 4.6 | 0.6 | 8.0 | 6.0 | | 5.6 | 1.0 | <.003 | <.0075 | 0.10 |
| CMSX-4 | | 6.0 | Rest | 10.0 | 0.6 | 6.0 | 6.0 | | 5.6 | 1.0 | | Re=3.0 | 0.10 |
| CMSX-6 | <.015 | 10.0 | Rest | 5.0 | 3.0 | <.10 | 2.0 | <.10 | 4.9 | 4.8 | <.003 | <.0075 | 0.10 |
| PWA 1480 SX | <.006 | 10.0 | Rest | 5.0 | | 4.0 | 12.0 | | 5.0 | 1.5 | <.0075 | <.0075 | |
| PWA 1483 SX | 0.07 | 12.2 | Rest | 9.0 | 1.9 | 3.8 | 5.0 | | 3.6 | 4.2 | 0.0001 | 0.002 | |
| Co-Basis-Feingußlegierungen | | | | | | | | | | | | | |
| FSX 414 | 0.25 | 29.0 | 10 | Rest | | 7.5 | | | | | 0.010 | | |
| X 45 | 0.25 | 25.0 | 10 | Rest | | 8.0 | | | | | 0.010 | | |
| ECY 768 | 0.65 | 24.0 | 10 | 51.7 | | 7.5 | 4.0 | | 0.25 | 0.3 | 0.010 | 0.05 | |
| MAR-M-509 | 0.65 | 24.5 | 11 | Rest | | 7.5 | 4 | | | 0.3 | 0.010 | 0.60 | |
| CM 247 | 0.07 | 8.3 | Rest | 10.0 | 0.5 | 9.5 | 3.2 | | 5.5 | 0.7 | | | 1.5 |

FIG 3

FIG 4

FIG 5

FIG 6

Europäisches Patentamt
European Patent Office
Office européen des brevets

# EUROPÄISCHER RECHERCHENBERICHT

**Nummer der Anmeldung**

EP 11 16 5301

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2009 051823 A1 (FRAUNHOFER GES FORSCHUNG [DE]; SIEMENS AG [DE]) 5. Mai 2011 (2011-05-05) * das ganze Dokument * ----- | 1-12 | INV. B23K26/34 C30B13/24 C30B29/52 F01D5/00 |
| A | GAEUMANN M ET AL: "SINGLE-CRYSTAL LASER DEPOSITION OF SUPERALLOYS: PROCESSING-MICROSTRUCTURE MAPS", ACTA MATERIALIA, ELSEVIER, OXFORD, GB, Bd. 49, Nr. 6, 2. April 2001 (2001-04-02), Seiten 1051-1062, XP001018288, ISSN: 1359-6454, DOI: 10.1016/S1359-6454(00)00367-0 * das ganze Dokument * ----- | 1-12 | |
| X | EP 0 861 927 A1 (SULZER INNOTEC AG [CH]) 2. September 1998 (1998-09-02) * das ganze Dokument * ----- | 1-12 | |

**RECHERCHIERTE SACHGEBIETE (IPC)**

B23K
C30B
F01D

Der vorliegende Recherchenbericht wurde für alle Patentansprüche erstellt

| Recherchenort | Abschlußdatum der Recherche | Prüfer |
|---|---|---|
| München | 18. Oktober 2011 | Wendl, Helen |

**ANHANG ZUM EUROPÄISCHEN RECHERCHENBERICHT**
**ÜBER DIE EUROPÄISCHE PATENTANMELDUNG NR.**

EP 11 16 5301

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

18-10-2011

| Im Recherchenbericht angeführtes Patentdokument | Datum der Veröffentlichung | Mitglied(er) der Patentfamilie | | Datum der Veröffentlichung |
|---|---|---|---|---|
| DE 102009051823 A1 | 05-05-2011 | WO | 2011054864 A1 | 12-05-2011 |
| EP 0861927 A1 | 02-09-1998 | CA | 2230323 A1 | 24-08-1998 |
| | | US | 6024792 A | 15-02-2000 |

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1204776 B1
- EP 1306454 A
- EP 1319729 A1
- WO 9967435 A
- WO 0044949 A
- EP 0486489 B1
- EP 0786017 B1
- EP 0412397 B1
- EP 1306454 A1
- US PS6024792 A
- EP 0892090 A1